# EUROPEAN PATENT SPECIFICATION

(11) **EP 0 836 119 B1**
(45) Date of publication and mention of the grant of the patent: **03.12.2003**
(21) Application number: 97308066.6
(22) Date of filing: 11.10.1997
(51) Int. Cl.: G03F 7/00, G03F 7/039, G03F 7/004

(54) **Chemically amplified resist composition**
Chemisch verstärkte Resistzusammensetzung
Composition chimiquement amplifiée pour réserve

(30) Priority: 11.10.1996 KR 9645396; 02.10.1997 KR 9751055
(43) Date of publication of application: 15.04.1998
(73) Proprietor: Samsung Electronics Co., Ltd., Suwon-city, Kyunggi Province (KR)
(72) Inventor: Yool, Kang, Sungnam-shi, Kyunggi-do (KR); Sang-Jun, Choi, Pundang-ku, Sungnam-shi, Kyunggi-do (KR); Dong-Won, Jung, Seoul (KR); Chun-Geun, Park, Paldal-ku, Suwon, Kyunggi-do (KR); Young-Bum, Koh, Sucho-ku, Seoul (KR)
(74) Representative: Sanderson, Nigel Paul

(56) References cited:
- EP-A- 0 794 458
- DD-A- 128 164
- US-A- 3 280 080
- T.I. WALLOW ET AL.: "Evaluation of Cycloolefin-Maleic Anhydride Alternating Copolymers as Single-Layer Photoresists for 193 nm Photolithography" PROC. SPIE-INT. SOC. OPT. ENG. (ADVANCES IN RESIST TECHNOLOGY AND PROCESSING XIII), vol. 2724, March 1996, pages 355-364, XP002053109
- DATABASE WPI Section Ch, Week 9215 Derwent Publications Ltd., London, GB; Class A14, AN 92-120182 XP002053110 & JP 04 063 810 A (KURARAY CO LTD) , 28 February 1992

## Description

### Field of the Invention

The present invention relates to chemically amplified resist compositions including polymers.

### Background of the Invention

With increasing integration of semiconductor devices, there is a heightened need to form finer patterns of subquarter micron capacity in photolithography processes. A photolithography technology has been proposed which utilises an ArF excimer laser (eg λ= 193 nm) for producing devices beyond the 1 giga capacity. This technology is intended to replace conventional KrF eximer lasers which use deep ultraviolet rays (eg λ= 248 nm). Accordingly it may be desirable to develop new chemically. amplified resist compositions for use with ArF eximer laser sources.

In general, the prerequisites for chemically amplified resist components for use with an ArF excimer laser may be identified as follows:
1. transmittance in the range of 193 nm;
2. excellent thermal characteristics, such as for example, high glass transition temperature (T_{g});
3. excellent adhesion to film materials;
4. excellent resistance to dry etching processes; and
5. capability of being developed using conventional developers;

An example of one polymer which has been developed with the objective of obtaining such properties is a tetrapolymer, namely poly (IBMA-MMA-tBMA-MAA) which is represented by the general formula:

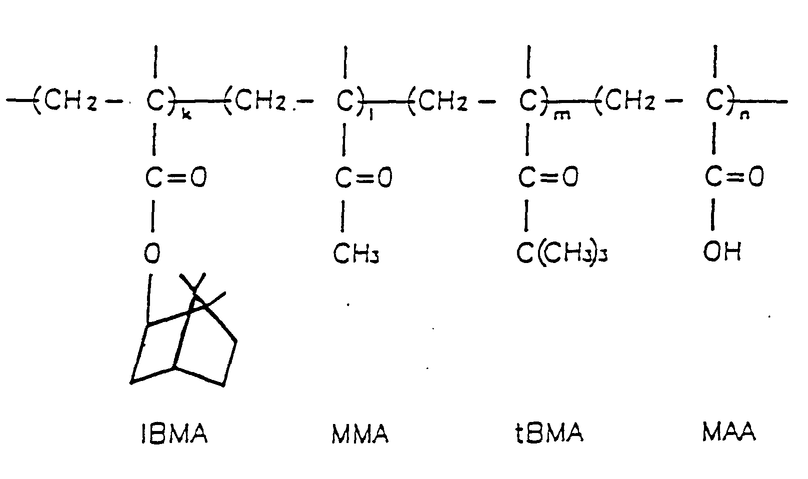

The above tetrapolymer however is not satisfactory for a number of reasons. In particular, the tetrapolymer has very weak resistance to etching processes and also exhibits weak adhesive properties. Additionally, a special developer may be needed for the development of the tetrapolymer. To potentially address these problems, a class of cyclopolymers have been processed which are of the general formula:

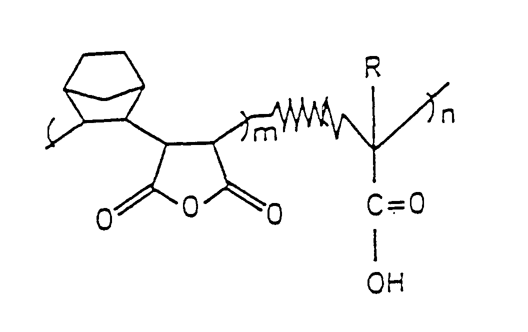

These cyclopolymers, however, also suffer from certain disadvantages. Specifically, the cyclopolymers have weak adhesive properties, and as a result lifting of the resist may occur. Moreover, a special developer which requires special separate preparation and which needs to be employed in a specific concentration range has to be used with the above cyclopolymers in place of generally accepted developers.

EP 0794458 A2 discloses a resist material for use in a lithographic process containing a polymer formed from a monomer which contains alicyclic moieties and at least one other monomer. The polymers are particularly advantageous when used in processes in which the exposing radiation is 193 nm. EP 0794458 A2 is relevant to the current application in respect of Article 54(3) EPC.

In Proc SPIE - Int. Soc. Opt. Eng., March 1996 Vol 2724 pp 355-364 there is disclosed a new class of photoresist matrix resins based on norbomene-maleic anhydride-acetic acid alternating copolymers for use in lithography at a wavelength of 193 and 248 nm. The use of photoacid generators, for example triphenylsulphonium triflate (TPS-Tf) is also discussed.

Finally, US 3280080 and DD 120164 describe the preparation of alternating norbornene and maleic anhydride copolymers.

### Summary of the Invention

In view of the above, it is an object of the present invention to provide chemically amplified resist compositions including polymers which have the required properties for use in chemically amplified resists for use with ArF lasers, and which exhibit strong resistance to dry etching processes, possess excellent adhesion to film materials, and may be developed using conventional developers.

It is an additional object of the present invention to provide chemically amplified resists having excellent resistance against wet-etching.

These and other objectives, features, and advantages of the present invention are provided by chemically amplified resists comprising specific polymers.

In one aspect, the invention relates to a chemically amplified resist composition comprising a copolymer having the formula: 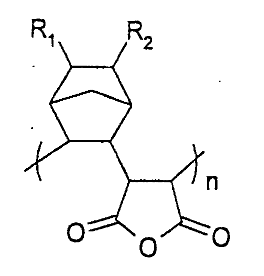 wherein R₁ and R₂ may be the same or different and are selected from the group consisting of hydrogen and a substituted or unsubstituted C₁ to C₁₀ aliphatic hydrocarbon, said substituted aliphatic hydrocarbon containing at least one substituent selected from hydroxy, carboxylic acid and carboxylic anhydride, provided that at least one of R₁ and R₂ is said substituted aliphatic hydrocarbon; n is an integer; and wherein said copolymer has a weight average molecular weight of from about 3,000 to about 100,000.

In another aspect, the invention provides a chemically amplified resist composition comprising a copolymer having the formula: 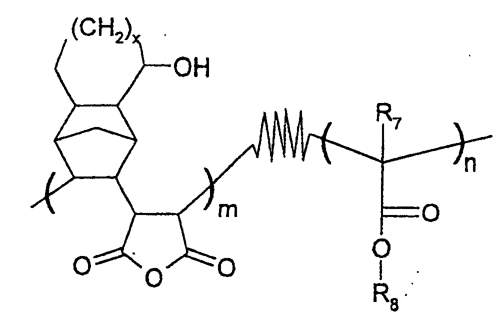 wherein x is selected such that the ring containing (CH₂)ₓ is selected from the group comprising C₅ to C₈ cyclic or alicyclic groups, R₇ is hydrogen or methyl, R₈ is selected from t-butyl, tetrahydropyranyl and adamantyl; m and n are integers; and wherein n/(m + n) ranges from 0.1 to 0.5.

### Brief Description of the Drawings

The above objectives and advantages of the present invention will become more apparent by describing in detail preferred embodiments thereof with reference to the attached drawings in which:
Figure 1 represents a Fourier Transform Infrared Radiation (FTIR) spectrum of a terpolymer according to the present invention;
Figure 2 is a graph illustrating the measured transmittance depending on the respective wavelengths of an ultraviolet (UV) spectrum for a resist composition according to the present invention;
Figure 3 is a graph illustrating the measured etch resistance of poly(OL/MA-t-BMA) as simulation results using Ring Parameter simulation for the poly(OL/MA-t-BMA) according to the present invention; and
Figure 4 is a graph illustrating the measured etch rate of the poly(OL₄₀/MA₆₀-t-BMA₂₀) as simulation results using Ohnishi and Ring parameters for the poly(OL₄₀/MA₆₀-t-BMA₂₀) according to the present invention.

### Detailed Description of Preferred Embodiments

The present invention will now be described more fully with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

The present invention in a first aspect relates to chemically amplified resist compositions including the copolymers represented by the general formula (I): 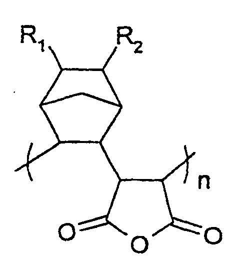 wherein R₁ and R₂ are as defined above.

In particular embodiments, R₁ may be hydrogen or a substituted C₁ to C₁₀ aliphatic hydrocarbon including hydroxyl, carboxylic acid or carboxylic anhydride groups as substituents where R₁ includes a hydroxyl substituent, R₁ is preferably -CH₂OH and R₂ is preferably hydrogen. Alternatively R₂ may be -CH₂OH and R₁ may be hydrogen.

In other particular embodiments R₁ may be hydrogen and R₂ may include a C₁ to C₁₀ aliphatic hydrocarbon containing acid substituent or a carboxylic anhydride substituent; R₁ may include a C₁ to C₁₀ aliphatic hydrocarbon containing a hydroxyl substituent and R₂ may include a C₁ to C₁₀ aliphatic hydrocarbon containing a carboxylic acid substituent or a carboxylic anhydride substituent; R₁ may include a C₁ to C₁₀ aliphatic hydrocarbon containing a carboxylic acid substituent and R₂ may include a C₁ to C₁₀ aliphatic hydrocarbon containing a carboxylic acid substituent or a carboxylic anhydride substituent; and R₁ and R₂ may include (or may together comprise) a C₁ to C₁₀ aliphatic hydrocarbon containing a carboxylic anhydride substituent.

The resist compositions of the present invention compromise photoacid generators. Any suitable photoacid generators may be used. Preferred photoacid generators include, but are not limited to, triarylsulfonium salts, diaryliodonium salts, sulfonates and mixtures thereof. The resist compositions may include various amounts of one or more polymers and photoacid generators. For example, in resist compositions containing terpolymers, photoacid generators may be present in amount ranging from about 1 to 20 weight percent based on the weights of the terpolymers. Preferably, the weight average molecular weights of terpolymers used in the resist composition range from about 5,000 to 20,000.

Although Applicants do not wish to be bound by any one theory, it is believed that an exposure mechanism of a polymer provided by the invention may be illustrated by the following reaction:

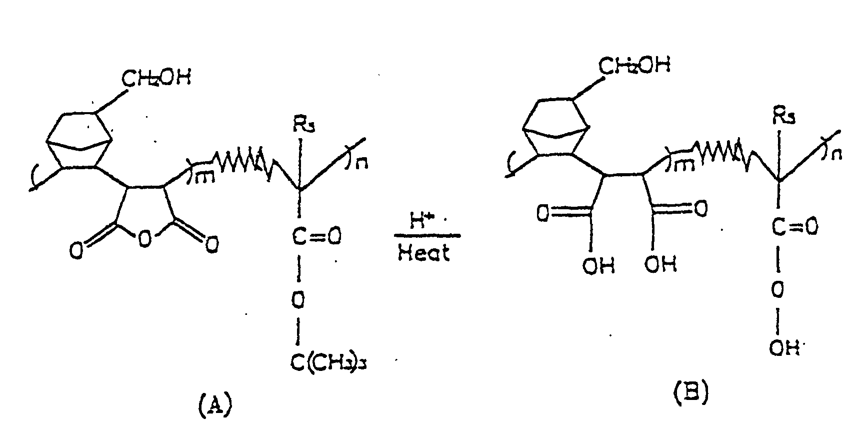

In the above mechanism, the pre-exposed polymer (A) is not very soluble in a developer, whilst polymer (B) formed as a result of postexposure is highly soluble in a developer.

The resist compositions of the invention are highly advantageous. The resist compositions of the present invention have excellent resistance to dry etching processes. The resist compositions of the present invention also possess excellent adhesion to film materials. Additionally, conventional developers, e.g. a 2.38wt% TMAH developer, may be used with the resist compositions.

The following examples are to be construed as illustrative of the present invention, and not as a limitation thereon.

### Example 1

### Synthesis of copolymer

The synthesis reaction for a copolymer according to this embodiment can be represented by the following formula:

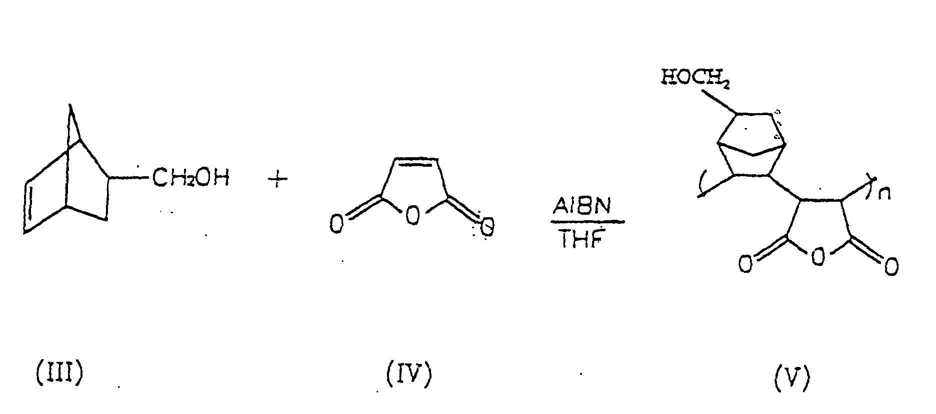

In this synthesis, 12.4g (0.1 mol) of 5-norbornene-2-methanol (III) and 9.8g (0.1 mol) of maleic anydride (IV) were dissolved in 100ml of tetrahydrofuran (THF) together with 1.31g (0.008. mol) of 2,2-azobisisobutyronitrile (AIBN). The reactants were purged with nitrogen (N₂)gas at a temperature of 65-70°C for about 24 hours so as to form the reaction product .

After polymerization, the reaction product was precipitated in n-hexane and the precipitates were dried in a vacuum oven maintained at 50°C for about 24 hours to obtain copolymer (V) product (yield:70%). The weight-average molecular weight of the obtained reaction product was 4,500 and the polydisperity (weight-average molecular weight/number average molecular weight) was 2.5.

The result of the FTIR spectral analysis for the thus-obtained copolymer (V) product was as follows:
FTIR (KBr) : 3400cm⁻¹(-OH), 1782cm⁻¹ (C=O)

### Example 2 (reference example)

### Synthesis of copolymer

The synthesis reaction for a copolymer according to this embodiment can be represented by the following formula:

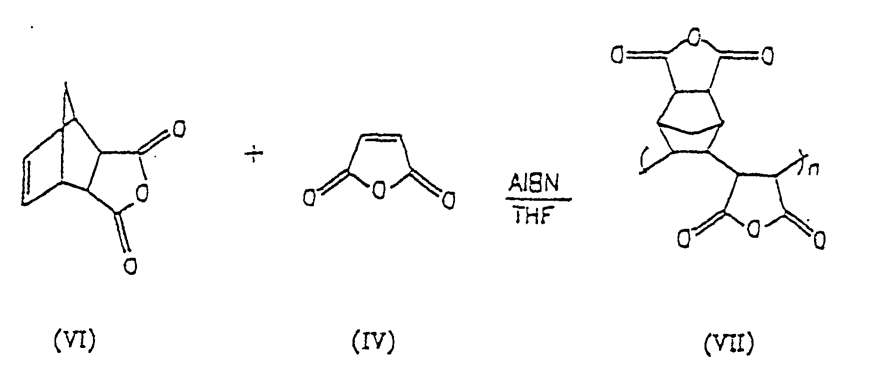

In this embodiment, 16.4g (0.1 mol) of 5-norbornene-2, 3-dicarboxylic acid (VI) and 9.8g (0.1 mol)of maleic anhydride (IV) were dissolved in 120ml of tetrahydrofuran (THF), and 1.31g (0.008 mol)of AIBN was added thereto. The product was polymerized under nitrogen (N₂) gas at 65-70°C for about 24 hours.

After polymerization, the reaction product was precipitated in n-hexane and the precipitates were dried in a vacuum oven maintained at 50°C for about 24 hours to obtain copolymer (VII) product (yield: 70%).

The weight-average molecular weight of the obtained reaction product was 5,500 and the polydispersity was 2.4.

### Example 3

### Synthesis of terpolymer

The synthesis reaction for a terpolymer according to this embodiment can be represented by the following formula: 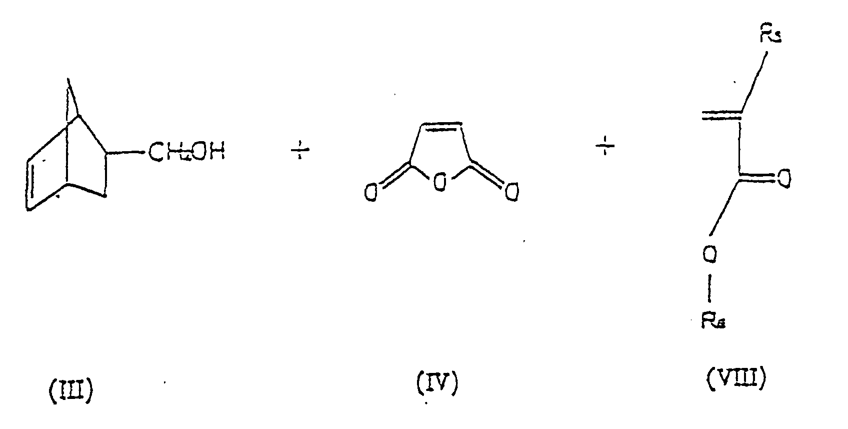 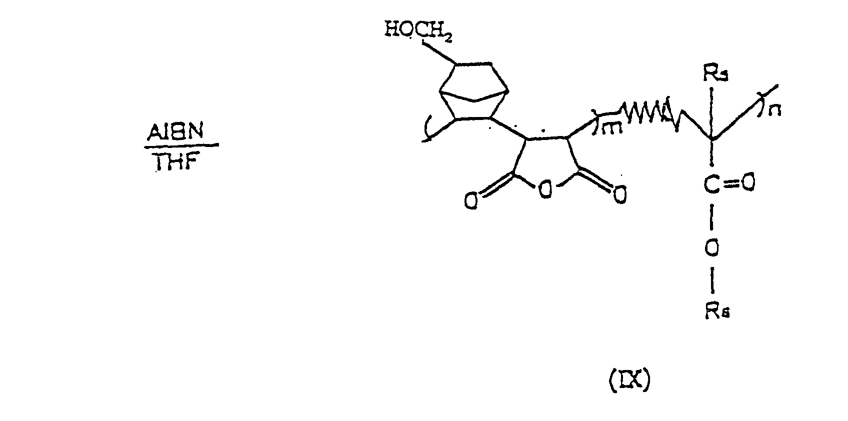 wherein R₅ is hydrogen or methyl, and R₆ is a t-butyl or tetrahydropranyl group.

### A. Synthesis of terpolymer wherein R₆ is a t-butyl group.

12.4g (0.1 mol) of 5-norbornene-2-methanol (II), 9.8g (0.1 mol) of maleic anhydride (IV), and 14g (0.1 mol) of t-butyl methacrylate (VIII) were dissolved in 150 ml of tetrahydrofuran (THF), and 1.64g (0. 01 mol) of AIBN was added thereto. The product was polymerized at a temperature of 66-70°C for about 24 hours.

After polymerization, the reaction product was precipitated in n-hexane and the precipitates were dried in a vacuum oven maintained at 50°C for about 24 hours to obtain terpolymer (IX) product (yield: 70%). The weight-average molecular weight of the obtained reaction product was 6,000, the polydispersity was 2.4 and the glass transition temperature (Tg) was 135°C.

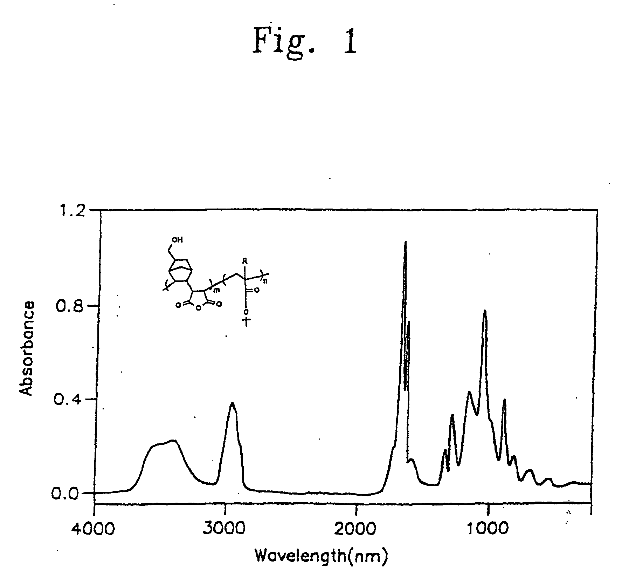

Figure 1 represents a Fourier Transform Infrared Radiation (FTIR) spectrum of the terpolymer (IX) obtained in the above manner and the results of the analysis are as follows:
IR (Kbr) : 3400 cm⁻¹ (-OH), 1784 cm⁻¹ (C=O), 1722 cm⁻¹ (C=O).

### B. Synthesis of terpolymer where in R₆ is a tetrahydropyranyl group

Terpolymer (IX) was obtained in a manner similar to that described in case A, except that 17g (0.1 mol) of tetrahydropyranyl methacrylate was used instead of t-butyl methacrylate. The yield of the terpolymer (IX) was 70%. The weight-average molecular weight of the obtained reaction product was 5,500 and polydispersity was 2.3.

The result of the FTIR spectral analysis of the thus-obtained terpolymer (IX) product was as follows:
IR (Kbr): 3400cm⁻¹ (-OH), 1784cm⁻¹ (C=O), 1723cm⁻¹ (C=O)

### Example 4

### Synthesis of a resist composition

1g of the terpolymer (IX) obtained from Example 3 was dissolved in 7g of propylene glycol monomethyl ether acetate (PGMEA). 0.02g of triphenyl sulfonium triflate was added thereto. The mixture was stirred thoroughly. Then, the resist composition was obtained by filtering the mixture using a 0.2µm microfilter. The obtained resist composition was applied to a wafer to form a coating film of about 0.5µm on the wafer.

The wafer having the coating film was baked at about 140°C for about 90 seconds, exposed to light using an ArF eximer laser having an numeric aperture of 0.45, baked again at about 140°C for about 90 seconds, and developed for about 60 seconds using about 2.38wt% of tetramethyl ammonium hydroxide (TMAH) solution.

When a photoresist pattern is formed on a semiconductor, substrate by exposing a film of a resist composition according to the present invention, using an exposure source having an energy of 31mj/cm² and a wavelength of 200 nm respectively and developing the film, excellent cross-sectional profiles were obtained at the respective wavelength bands.

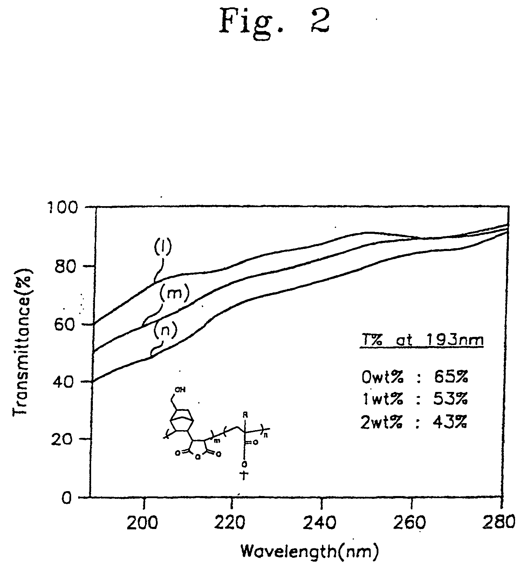

Figure 2 is a graph illustrating the measured' transmittance versus the wavelengths of an ultraviolet (UV) spectrum for a resist composition according to the present invention. In Fig. 2 curve (l) indicates the transmittance of a pure resist composition to which no photoacid generator (PAG) has been added, curve (m) indicates the transmittance of a resist composition to which PAG is added at a level of 1 wt% and curve (n) indicates the transmittance of a resist composition to which PAG has been added at a level of 2 wt%. As can be seen in Figure 2; at a wavelength of 193nm, the measured transmittances of (1) the pure resist composition, (2) the resist composition with 1 wt% PAG added thereto, and (3) the resist composition with 2 wt% PAG added thereto was 65%, 53% and 43%, respectively.

### Example 5

The poly (octalol / maleic anhydride-tert-butyl methacrylate: OL/MA-t-BMA) according to this embodiment can be obtained by following the synthesis steps.

### A. Synthesis of octalone monomer

The synthesis reaction of octalone monomer according to this embodiment can be represented by the following formula: 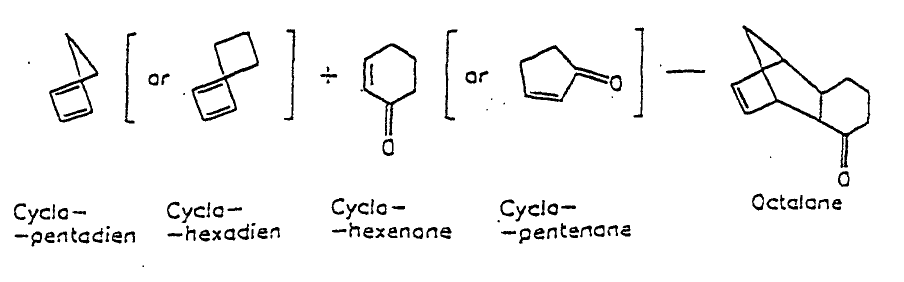 4.8g (50mmol) of 2-cyclohexanone dissolved in 100ml of dry toluene and 1.66g (12.5mmol) of aluminium chloride dissolved in 100ml of dry toluene were added thereto. The mixture was purged with nitogen (N₂) gas and stirred thoroughly at room temperature for about 60 minutes. Also, 19.8g (300mmol) of cyclopentadiene dissolved in dry toluene was added to the stirred mixture. The reactants were reacted with one another at a temperature of about 40°C for about 7 hours so as to form the reaction product.

After the reaction product was mixed with cooling water, a process step for extracting the reaction product was carried out using ethylether solution. Then, the reaction product was extracted by cleaning it with saturated brine and drying it with MgSO₄ solution. Next, moisture in the extracted reaction product was extracted by evaporation under vacuum and the remaining solution was passed through a chromatography column using a ratio of hexane to ether of 9:1, to extract the octalone monomer. The octalone monomer produced thus has two diastereoisomer an endo and exo.

The octalone monomer produced thus has characteristics as listed hereunder:
IR: 3, 060 cm⁻¹ (Olefinic CH) 1,700 cm⁻¹ (C=O)
¹H No : δ 0.7-0.9 (1H,4), 1.2-1.5 (2H, CH₂ Bridge), 1.6-1.85 (2H,3), 1.85-1.9 (1H,2), 1.9-2.0 (1H,4), 2.31 (1H,2), 2.6-2.73 (2H,9,10), 2 .88 (1H,5), 3 .26 (1H,8), 6.01-6.17 (2H,6,7)

### B. Synthesis of octalol monomer

The synthesis reaction of octalol monomer according to this embodiment can be represented by the following formula: 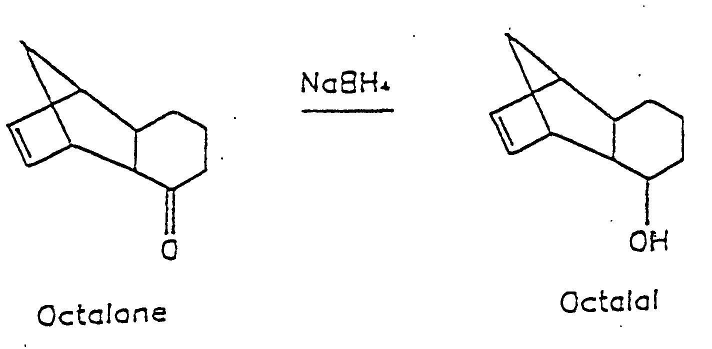 3.783g (0.1mol) of sodium borohydride (NaBH₄) was dissolved in 200ml of diethylether and then the octalone monomer obtained from Synthesis step (A) was introduced thereto to form a reaction mixture. The reaction mixture was refluxed for about 12 hours, and subsequently poured into a large volume of water and was neutralized with HCl solution. Diethylether was added to the neutralized solution. After drying the reaction product with MgSO₄ solution, moisture in the reaction product was evaporated under vacuum, so that octalol monomer could be extracted. The octalol monomer produced thus has characteristics as listed hereunder.
IR: 3,619 cm⁻¹ (Alcoholic OH) , 3,060 cm⁻¹ (Olefinic CH)
¹H NO: δ 2.8-2.9 (2H, 6, 11), 6.1-6.3 (2H, 8, 9) , 4.1 (1H, 1)

### C. Synthesis of poly (OL/MA-t-BMA)

The synthesis reaction of poly(OL/MA-t-BMA) according to this embodiment can be represented by the following formula: 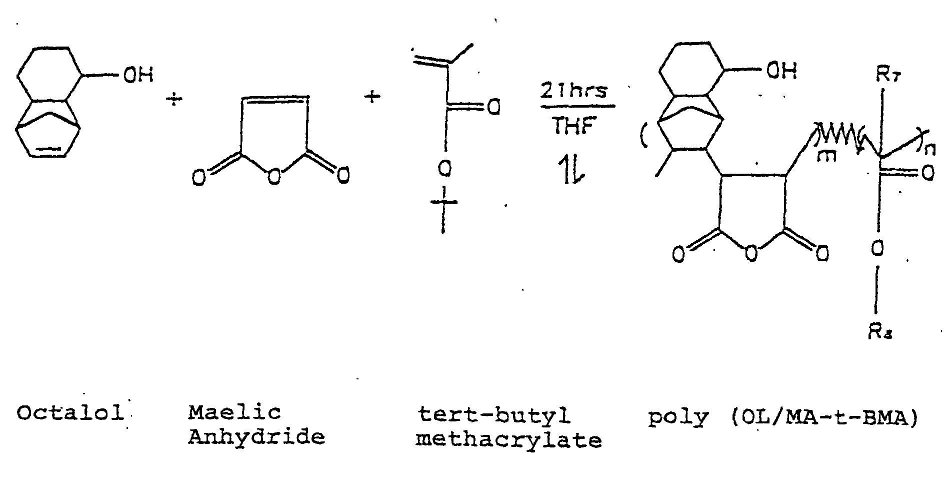 6.569g (20mmol) of octalol, 5.884g (60mmol) of maleic anhydride, and 2.84g. (20mmol) of t-BMA (tert-butylmethacrylate) were mixed to 62ml of tetrahydrofuran (THF) and refluxed with 1 mol% of polymerization initiator at a temperature of about 70°C for about 21 hours so as to form a reaction product. After cooling the reaction product, it was precipitated in n-hexane solution and dried in a vacuum dry oven for about 24 hours. As a result, poly(OL/MA-t-BMA) serving as a base polymer was obtained.

In the formula, R₇ is selected from the group consisting of hydrogen and methyl, R₈ is selected from the group consisting of t-butyl, tetrahyropyranyl and adamantyl, and m and n are each integers. The ratios n/(m+n) range from about 0.1 to about 0.5.

The resist composition comprises from about 0.5 to 10 weight percent of the photoacid generator which is based on the weight of the polymer defined by the formula and which is selected from the group consisting of triarylsulfonium salts, diaryliodonium salts, and mixtures thereof. The polymer has a weight average molecular weight of from about 2,000 to about 100,000.

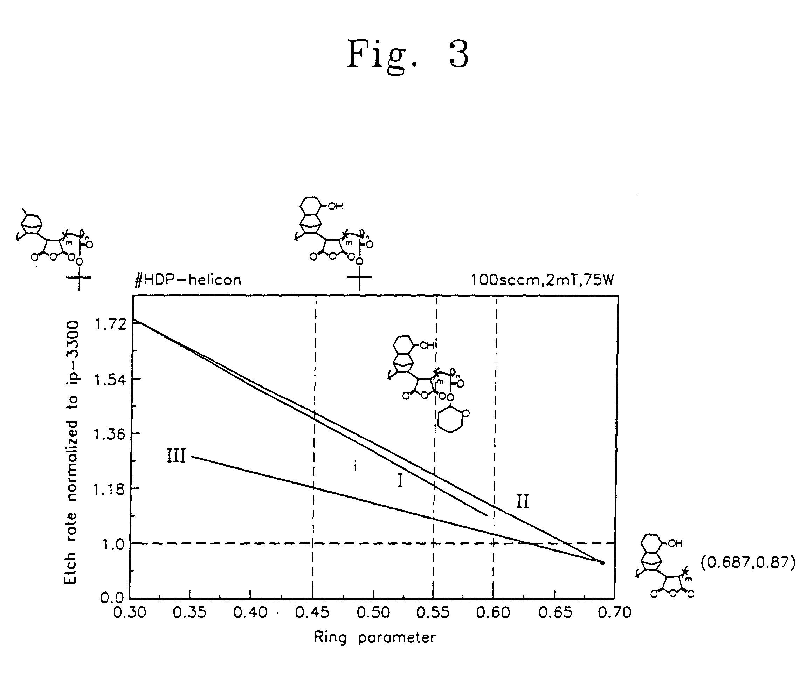

Figure 3 is a graph illustrating the measured etch resistance of poly (OL/MA-t-BMA) as simulation results using Ring Parameter simulation for the poly (OL/MA-t-BMA) according to the present invention. In Figure 3, line (I) indicates an etch rate of a conventional polymer to which maleic anhydride is added, line (II) indicates a minimum etch resistance of the poly (OL/MA-t-BMA) as simulation results and line (III) indicates an etch resistance of the poly (OL/MA-t-BMA) which was actually presumed.

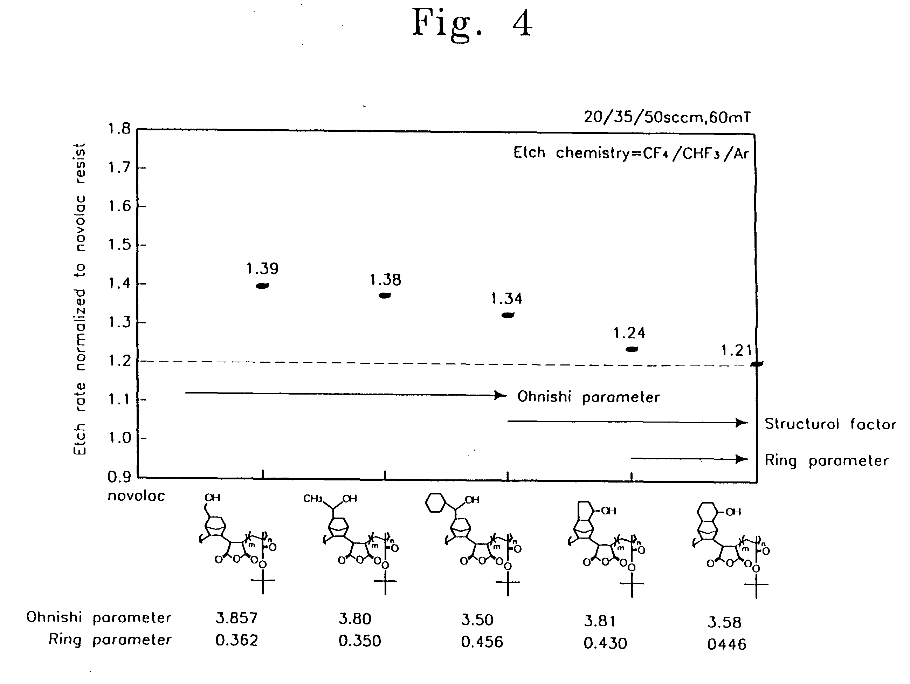

Figure 4 is a graph illustrating the measured etch rate of the poly(OL₄₀/MA₆₀-t-BMA₂₀)as simulation results using Ohnishi and Ring Parameters for the poly(OL₄₀/MA₆₀-t-BMA₂₀) according to the present invention. The simulation results shown in Figure 4 can be obtained using CF₄/CHF₃/Ar as an etch chemistry for the etch rate test. This test was carried out under the conditions of each 20/35/50 SCCM's, 60mT, and 80G in the test equipment called "MERIE type P-5000".

As can be seen from Figures 3 and 4, the conventional ArF resist has an etch rate of about 1.39, but the poly(OL/MA-t-BMA) according to the present invention has an etch rate between 1.24 and 1.21. Therefore, the poly(OL/MA-t-MBA) of the present invention can have excellent etch resistance in addition to excellent adhesion.

## Claims

1. A chemically amplified resist composition comprising a copolymer having the formula: 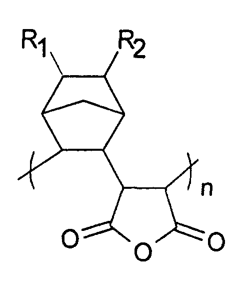 wherein R₁ and R₂ may be the same or different and are selected from the group consisting of hydrogen and a substituted or unsubstituted C₁ to C₁₀ aliphatic hydrocarbon, said substituted aliphatic hydrocarbon containing at least one substituent selected from hydroxy, carboxylic acid and carboxylic anhydride, provided that at least one of R₁ and R₂ is said substituted aliphatic hydrocarbon; n is an integer; and wherein said copolymer has a weight average molecular weight of from about 3,000 to about 100,000.

2. A chemically amplified resist composition as claimed in claim 1 wherein R₂ is hydrogen.

3. A chemically amplified resist composition as claimed in claim 1 wherein R₁ is hydrogen.

4. A chemically amplified resist composition as claimed in claim 1 wherein R₁ is a substituted C₁ to C₁₀ aliphatic hydrocarbon containing at least one hydroxy substituent.

5. A chemically amplified resist composition as claimed in claim 1 wherein R₁ is a substituted C₁ to C₁₀ aliphatic hydrocarbon containing at least one carboxylic acid substituent.

6. A chemically amplified resist composition as claimed in claim 5 wherein R₁ is a C₁ to C₁₀ aliphatic hydrocarbon containing a carboxylic acid.

7. A chemically amplified resist composition as claimed in claim 1 wherein R₁ is a substituted C₁ to C₁₀ aliphatic hydrocarbon containing at least one carboxylic anhydride substituent.

8. A chemically amplified resist composition as claimed in claim 7 wherein R₁ is a C₁ to C₁₀ aliphatic hydrocarbon containing a carboxylic anhydride.

9. A chemically amplified resist composition as claimed in any of claims 3 to 8 wherein R₂ is a substituted C₁ to C₁₀ aliphatic hydrocarbon containing at least one hydroxy substituent.

10. A chemically amplified resist composition as claimed in any of claims 3 to 8 wherein R₂ is a substituted C₁ to C₁₀ aliphatic hydrocarbon containing at least one carboxylic acid substituent.

11. A chemically amplified resist composition as claimed in claim 10 wherein R₂ is a C₁ to C₁₀ aliphatic hydrocarbon containing a carboxylic acid.

12. A chemically amplified resist composition as claimed in any of claims 3 to 8 wherein R₂ is a substituted C₁ to C₁₀ aliphatic hydrocarbon containing at least one carboxylic anhydride substituent.

13. A chemically amplified resist composition as claimed in claim 12 wherein R₂ is a C₁ to C₁₀ aliphatic hydrocarbon containing a carboxylic anhydride.

14. A chemically amplified resist composition comprising a copolymer having the formula: 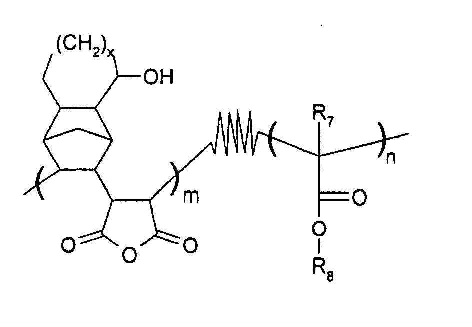 wherein x is selected such that the ring containing (CH₂)ₓ is selected from the group comprising C₅ to C₈ cyclic or alicyclic groups, R₇ is hydrogen or methyl, R₈ is selected from t-butyl, tetrahydropyranyl and adamantyl; m and n are integers; and wherein n/(m + n) ranges from 0.1 to 0.5.

## Patentansprüche

1. Chemisch verstärkte Resistzusammensetzung, die ein Copolymer umfasst, das folgende Formel besitzt: 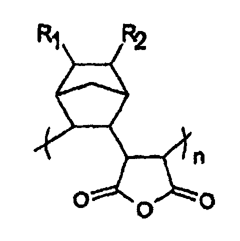 worin R₁ und R₂ gleich oder verschieden sein können und ausgewählt sind aus der Gruppe, bestehend aus Wasserstoff und einem substituierten oder unsubstituierten aliphatischen C₁- bis C₁₀-Kohlenwasserstoff, wobei dieser substituierte aliphatische Kohlenwasserstoff wenigstens einen Substituenten enthält, der ausgewählt ist aus Hydroxy, Carbonsäure und Carbonsäureanhydrid, vorausgesetzt, dass wenigstens einer von R₁ und R₂ dieser substituierte aliphatische Kohlenwasserstoff ist;
n eine ganze Zahl ist und worin dieses Copolymer ein durchschnittliches Molekulargewicht von ungefähr 3000 bis ungefähr 100000 besitzt.

2. Chemisch verstärkte Resistzusammensetzung gemäß Anspruch 1, worin R₂ Wasserstoff ist.

3. Chemisch verstärkte Resistzusammensetzung gemäß Anspruch 1, worin R₁ Wasserstoff ist.

4. Chemisch verstärkte Resistzusammensetzung gemäß Anspruch 1, worin R₁ ein substituierter aliphatischer C₁- bis C₁₀-Kohlenwasserstoff ist, der wenigstens einen Hydroxysubstituenten enthält.

5. Chemisch verstärkte Resistzusammensetzung gemäß Anspruch 1, worin R₁ ein substituierter aliphatischer C₁- bis C₁₀-Kohlenwasserstoff ist, der wenigstens einen Carbonsäuresubstituenten enthält.

6. Chemisch verstärkte Resistzusammensetzung gemäß Anspruch 5, worin R₁ ein aliphatischer C₁- bis C₁₀-Kohlenwasserstoff ist, der eine Carbonsäure enthält.

7. Chemisch verstärkte Resistzusammensetzung gemäß Anspruch 1, worin R₁ ein substituierter aliphatischer C₁- bis C₁₀-Kohlenwasserstoff ist, der wenigstens einen Carbonsäureanhydridsubstituenten enthält.

8. Chemisch verstärkte Resistzusammensetzung gemäß Anspruch 7, worin R₁ ein aliphatischer C₁- bis C₁₀-Kohlenwasserstoff ist, der ein Carbonsäureanhydrid enthält.

9. Chemisch verstärkte Resistzusammensetzung gemäß irgendeinem der Ansprüche 3 bis 8, worin R₂ ein substituierter aliphatischer C₁bis C₁₀-Kohlenwasserstoff ist, der wenigstens einen Hydroxysubstituenten enthält.

10. Chemisch verstärkte Resistzusammensetzung gemäß irgendeinem der Ansprüche 3 bis 8, worin R₂ ein substituierter aliphatischer C₁bis C₁₀-Kohlenwasserstoff ist, der wenigstens einen Carbonsäuresubstituenten enthält.

11. Chemisch verstärkte Resistzusammensetzung gemäß Anspruch 10, worin R₂ ein aliphatischer C₁- bis C₁₀-Kohlenwasserstoff ist, der eine Carbonsäure enthält.

12. Chemisch verstärkte Resistzusammensetzung gemäß irgendeinem der Ansprüche 3 bis 8, worin R₂ ein substituierter aliphatischer C₁bis C₁₀-Kohlenwasserstoff ist, der wenigstens einen Carbonsäureanhydridsubstituenten enthält.

13. Chemisch verstärkte Resistzusammensetzung gemäß Anspruch 12, worin R₂ ein aliphatischer C₁- bis C₁₀-Rohlenwasserstoff ist, der ein Carbonsäureanhydrid enthält.

14. Chemisch verstärkte Resistzusammensetzung, welche ein Copolymer umfasst, welches folgende Formel besitzt: 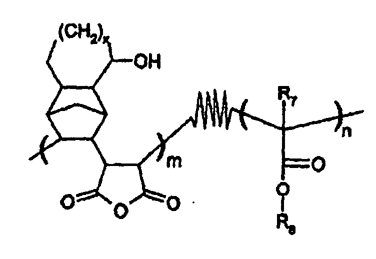 worin X so ausgewählt ist, dass der Ring, welcher (CH₂)ₓ enthält, ausgewählt ist aus der Gruppe, die zyklische oder alizyklische C₅- bis C₈-Gruppen umfasst, R₇ Wasserstoff oder Methyl ist, R₈ ausgewählt ist aus t-Butyl, Tetrahydropyranyl und Adamantyl; m und n ganze Zahlen sind und worin n/(m + n) im Bereich von 0,1 bis 0,5 liegt.

## Revendications

1. Composition de réserve chimiquement amplifiée comprenant un copolymère ayant la formule : 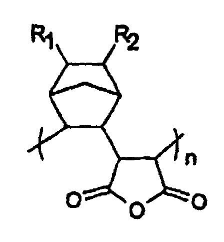 Où R₁ et R₂ peuvent être identiques ou différents et sont choisis parmi le groupe comprenant l'hydrogène et un hydrocarbure aliphatique substitué ou non-substitué C₁ à C₁₀, ledit hydrocarbure aliphatique substitué contenant au moins un substituant choisi parmi l'hydroxy, l'acide carboxylique et l'anhydride carboxylique, au moins un des R₁ et R₂ étant l'hydrocarbure aliphatique substitué ; n est un nombre entier ; **caractérisée en ce que** ledit copolymère a un poids moléculaire moyen allant d'environ 3 000 à environ 100 000.

2. Composition de réserve chimiquement amplifiée selon la revendication 1, **caractérisée en ce que** R₂ est l'hydrogène.

3. Composition de réserve chimiquement amplifiée selon la revendication 1, **caractérisée en ce que** R₁ est l'hydrogène.

4. Composition de réserve chimiquement amplifiée selon la revendication 1, **caractérisée en ce que** R₁ est un hydrocarbure aliphatique substitué C₁ à C₁₀ contenant au moins un substituant hydroxy.

5. Composition de réserve chimiquement amplifiée selon la revendication 1, **caractérisée en ce que** R₁ est un hydrocarbure aliphatique substitué C₁ à C₁₀ contenant au moins un substituant acide carboxylique.

6. Composition de réserve chimiquement amplifiée selon la revendication 5, **caractérisée en ce que** R₁ est un hydrocarbure aliphatique C₁ à C₁₀ contenant un acide carboxylique.

7. Composition de réserve chimiquement amplifiée selon la revendication 1, **caractérisée en ce que** R₁ est un hydrocarbure aliphatique substitué C₁ à C₁₀ contenant au moins un substituant anhydride carboxylique.

8. Composition de réserve chimiquement amplifiée selon la revendication 7, **caractérisée en ce que** R₁ est un hydrocarbure aliphatique C₁ à C₁₀ contenant un anhydride carboxylique.

9. Composition de réserve chimiquement amplifiée selon l'une des revendications 3 à 8, **caractérisée en ce que** R₂ est un hydrocarbure aliphatique substitué C₁ à C₁₀ contenant au moins un substituant hydroxy.

10. Composition de réserve chimiquement amplifiée selon l'une des revendications 3 à 8, **caractérisée en ce que** R₂ est un hydrocarbure aliphatique substitué C₁ à C₁₀ contenant au moins un substituant acide carboxylique.

11. Composition de réserve chimiquement amplifiée selon la revendication 10, **caractérisée en ce que** R₂ est un hydrocarbure aliphatique C₁ à C₁₀ contenant un acide carboxylique.

12. Composition de réserve chimiquement amplifiée selon l'une des revendications 3 à 8, **caractérisée en ce que** R₂ est un hydrocarbure aliphatique substitué C₁ à C₁₀ contenant au moins un substituant anhydride carboxylique.

13. Composition de réserve chimiquement amplifiée selon la revendication 12, **caractérisée en ce que** R₂ est un hydrocarbure aliphatique C₁ à C₁₀ contenant un anhydride carboxylique.

14. Composition de réserve chimiquement amplifiée comprenant un copolymère ayant la formule : 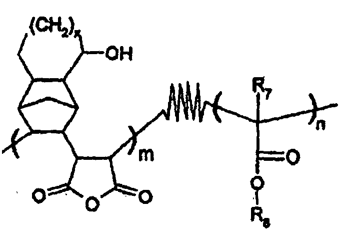 où x est choisi de manière à ce que le cycle contenant (CH₂)ₓ est choisi parmi le groupe comprenant les groupes alicycliques ou cycliques C₅ à C₈, R₇ est l'hydrogène ou le méthyl, R₈ est choisi parmi le t-butyl, le tétrahydropyranyl et l'adamantyl ; m et n sont des nombres entiers ; et où n/(n+m) varie de 0.1 à 0.5.
